# EUROPEAN PATENT APPLICATION

(11) **EP 4 622 411 A1**
(43) Date of publication of application: **24.09.2025**
(21) Application number: 23896374.8
(22) Date of filing: 30.10.2023
(51) Int. Cl.: H05K 7/20

(54) **METAL SUBSTRATE HEAT DISSIPATION STRUCTURE AND PHOTOVOLTAIC POWER OPTIMIZER**

(30) Priority: 30.11.2022 CN 202211525342
(71) Applicant: Huawei Digital Power Technologies Co., Ltd., Shenzhen, Guangdong 518043 (CN)
(72) Inventor: CHEN, Shanwu, Shenzhen, Guangdong 518043 (CN); CHENG, Jiebin, Shenzhen, Guangdong 518043 (CN); SONG, Weiping, Shenzhen, Guangdong 518043 (CN); TANG, Qingguo, Shenzhen, Guangdong 518043 (CN); TAO, Wei, Shenzhen, Guangdong 518043 (CN)
(74) Representative: Maiwald GmbH
(86) International application number: PCT/CN2023/127642
(87) International publication number: WO 2024/114220

(57) **Abstract**

The present invention provides a metal substrate heat dissipation structure and a photovoltaic power optimizer. The metal substrate heat dissipation structure includes a printed circuit board PCB, a multi-layer metal plate, and a power device. The multi-layer metal plate includes a first metal layer, a second metal layer, a first insulation layer, and a second insulation layer. The power device is disposed on the first metal layer, to implement power interconnection between power devices. The PCB is electrically connected to the first metal layer, to enable a control device on the PCB to control the power device on the first metal layer. The first metal layer is electrically connected to the second metal layer, to implement an electromagnetic shielding function. The first insulation layer and the second insulation layer respectively implement functional insulation effect and reinforced insulation effect. The metal substrate heat dissipation structure fully utilizes a strong heat dissipation feature of a metal substrate, effectively simplifies the heat dissipation structure, reduces production difficulty and material costs of the heat dissipation structure, reduces interface thermal resistance, and improves heat dissipation efficiency.

## Description

### TECHNICAL FIELD

This application relates to the field of heat dissipation technologies, and in particular, to a metal substrate heat dissipation structure and a photovoltaic power optimizer.

### BACKGROUND

A buck circuit (buck circuit) inside a photovoltaic power optimizer may generally relate to power devices such as a diode and a metal-oxide-semiconductor field-effect transistor (Metal-Oxide-Semiconductor Field-Effect Transistor, MOSFET), which is briefly referred to as a MOS transistor. Switching losses of these power devices in a working state are mostly dissipated in a form of heat, which is prone to cause an increase in a temperature of the power devices. However, there is a specific limitation to temperature tolerance of the power device. In this case, if heat generated by the power device cannot be conducted in time, a working capability and performance of the power device are likely to sharply deteriorate, working stability is severely affected, and working efficiency is reduced. In addition, a service life of the power device is closely related to a working temperature of the power device. A lower working temperature facilitates a longer service life of the power device. Besides, in a long-time working state, a power device with a high temperature may further cause high-temperature baking to a control device with a low temperature on a printed circuit board (Printed circuit board, PCB). This severely affects working stability of the control device. Therefore, it is particularly important to conduct heat generated by a semiconductor power device in time.

### SUMMARY

Embodiments of this application provide a metal substrate heat dissipation structure and a photovoltaic power optimizer. The metal substrate heat dissipation structure can resolve problems of low heat dissipation efficiency, a complex structure, and high material costs of a heat dissipation structure in an existing photovoltaic power optimizer.

According to a first aspect, an embodiment of this application provides a metal substrate heat dissipation structure. The metal substrate heat dissipation structure includes a PCB, a multi-layer metal plate, and a power device. The multi-layer metal plate includes a first metal layer, a first insulation layer, a second metal layer (equivalent to a metal substrate layer 403 in Embodiment 3), and a second insulation layer that are sequentially stacked. The power device is disposed on a surface that is of the first metal layer and that is away from the first insulation layer. The PCB is electrically connected to the first metal layer, to enable a control device on the PCB to control the power device on the first metal layer. A static point on the first metal layer is electrically connected to the second metal layer, to implement electromagnetic shielding.

According to the foregoing technical solution, the metal substrate heat dissipation structure fully utilizes an advantage of the PCB on which wiring can be arranged flexibly to arrange a complex control circuit and dispose the control device on the PCB, and disposes a power device with a large amount of generated heat on the first metal layer of the multi-layer metal plate. The control device on the PCB controls the power device on the first metal layer through electrical interconnection between the PCB and the first metal layer. The structure is simple and is easy to implement.

In addition, for the multi-layer metal plate, the first metal layer of the multi-layer metal plate can not only implement power interconnection between power devices, but also facilitate an electrical connection between the PCB and the power device, so that the control device on the PCB controls the power device on the first metal layer. The first insulation layer of the multi-layer metal plate is disposed, so that functional insulation can be implemented. The second metal layer of the multi-layer metal plate may be connected to the static point on the first metal layer through sidewall soldering/tin plating or a via, to achieve shielding effect for noise feedback. In addition, the second metal layer has a strong heat dissipation capability, and may further enhance heat dissipation. A thickness of the second insulation layer of the multi-layer metal plate may be more than 10 mil, to achieve regulatory (regulatory) insulation effect. The multi-layer metal plate fully utilizes a feature of a strong heat dissipation capability of the second metal layer, and the first insulation layer, the second insulation layer, the first metal layer, and the second metal layer are pressed, so that the structure is simplified, interface thermal resistance is reduced, heat dissipation efficiency is improved, a quantity of used MOS transistors is reduced, and material costs are reduced.

In a possible implementation, the multi-layer metal plate further includes a third metal layer (equivalent to a metal substrate layer 205 in Embodiment 1 or Embodiment 2), and the third metal layer is disposed under the second insulation layer. In other words, the multi-layer metal plate further includes the first metal layer, the first insulation layer, the second metal layer, the second insulation layer, and the third metal layer that are sequentially stacked. The second metal layer is connected to the static point on the first metal layer through sidewall soldering/tin plating, the via, or the like, to implement an electromagnetic shielding function. The third metal layer has a strong heat dissipation capability, and can implement quick heat dissipation of the multi-layer metal plate. In addition, the third metal layer may further have a specific support function to stabilize a structure of the multi-layer metal plate.

In a possible implementation, projection areas of the first metal layer and the first insulation layer of the multi-layer metal plate in a stacking direction of the multi-layer metal plate are less than or equal to projection areas of the second metal layer and the second insulation layer in the stacking direction of the multi-layer metal plate. That is, there is a specific distance between edges of the first metal layer (equivalent to a metal layer 401 in Embodiment 3) and the first insulation layer (equivalent to an insulation layer 403 in Embodiment 3) and edges of the second metal layer (equivalent to a metal substrate layer 403 in Embodiment 3) and the second insulation layer (equivalent to an insulation layer 404 in Embodiment 3). The distance may facilitate sidewall soldering/tin plating or the via. In addition, the edges of the first metal layer and the first insulation layer may alternatively be consistent with the edges of the second metal layer and the second insulation layer. In this case, electrical interconnection between the first metal layer and the second metal layer may be implemented through a through via. The structure is simple and is easy to process.

In a possible implementation, projection areas of the first metal layer, the first insulation layer, and the second metal layer of the multi-layer metal plate in a stacking direction of the multi-layer metal plate are less than projection areas of the second insulation layer and the third metal layer in the stacking direction of the multi-layer metal plate. That is, there is a specific distance between edges of the first metal layer (equivalent to a metal layer 201 in Embodiment 1 or 2), the first insulation layer (equivalent to an insulation layer 202 in Embodiment 1 or 2), and the second metal layer (equivalent to a metal layer 203 in Embodiment 1 or 2) and edges of the second insulation layer (equivalent to an insulation layer 204 in Embodiment 1 or 2) and the third metal layer (equivalent to the metal substrate layer 205 in Embodiment 1 or 2), to implement better regulatory insulation effect.

In a possible implementation, a thickness of the second insulation layer of the multi-layer metal plate is greater than a thickness of the first insulation layer, to implement better regulatory insulation effect.

In a possible implementation, when a volume or an area of the PCB is small, in addition to disposing the power device such as a MOS transistor on the first metal layer of the multi-layer metal plate, the PCB may also be integrally disposed on the first metal layer. The PCB is integrally disposed on the first metal layer, so that a volume of the metal substrate heat dissipation structure can be reduced, a manufacturing process can be simplified, and material costs can be reduced. In addition, because an area of the multi-layer metal plate is large, heat dissipation effect of the corresponding metal substrate heat dissipation structure is also good.

Besides, when an area or a volume of the multi-layer metal plate is small, an aperture may be provided in the middle of the PCB in the stacking direction, and an edge of the aperture of the PCB is fastened to the surface that is of the first metal layer and that is in a direction away from the first insulation layer. The structure is simple and is easy to implement.

Besides, when a volume or an area of the PCB is large, the PCB may be mounted on the first metal layer in the stacking direction of the multi-layer metal plate. In other words, there is a specific spacing between the PCB and the first metal layer in the stacking direction of the multi-layer metal plate. Specifically, a metal guide pillar or a metal frame may be disposed on the first metal layer of the multi-layer metal plate, and the PCB is supported by the metal guide pillar or the metal frame to be mounted in the stacking direction of the multi-layer metal plate. In addition to the support function, the metal guide pillar may further implement the electrical interconnection between the PCB and the first metal layer. The PCB is mounted in the stacking direction of the multi-layer metal plate, so that high-temperature baking of a power device with a larger amount of generated heat on the first metal layer (for example, the MOS transistor) to a control device with a smaller amount of generated heat on the PCB can be alleviated, and working stability of the control device can be improved.

In a possible implementation, the metal substrate heat dissipation structure further includes a heat sink or a metal housing. The heat sink or the metal housing is connected to the multi-layer metal plate. A plurality of heat dissipation fins are provided on the heat sink, and can increase a heat exchange area and improve heat exchange efficiency.

In a possible implementation, the metal substrate heat dissipation structure is in direct contact with the heat sink or the metal housing. In other words, the metal substrate heat dissipation structure is fastened to the heat sink or the metal housing through a screw. In addition, the metal substrate heat dissipation structure may alternatively be in indirect contact with the heat sink. To be specific, the metal substrate heat dissipation structure is bonded to the heat sink or the metal housing through silicone grease, gel, or heat-cured glue, to ensure that the metal substrate heat dissipation structure is closely attached to the heat sink or the metal housing, increase the heat exchange area, and avoid impact of air on the heat dissipation efficiency.

In a possible implementation, a part that is of the heat sink and that is in contact with the multi-layer metal plate is of a protrusion structure, and the protrusion structure and the heat sink are of an integrated structure or a split structure (the protrusion structure is connected to a heat dissipation device through soldering, riveting, bonding, or the like). The protrusion structure is disposed, so that a regulatory distance can be increased, to better ensure personal safety.

In a possible implementation, an insulation layer is disposed around the protrusion structure to implement reinforced insulation.

According to a second aspect, an embodiment of this application further provides a photovoltaic power optimizer. The photovoltaic power optimizer includes the metal substrate heat dissipation structure according to any one of the first aspect and a housing of the photovoltaic power optimizer, and the metal substrate heat dissipation structure is located in accommodation space enclosed by the housing of the photovoltaic optimizer.

With reference to the second aspect, in a first possible implementation of the second aspect, a gap between the metal substrate heat dissipation structure and the housing of the photovoltaic power optimizer is filled with a potting compound, to strengthen a heat dissipation capability of the metal substrate heat dissipation structure and shorten a regulatory distance required by the metal substrate heat dissipation structure.

### BRIEF DESCRIPTION OF DRAWINGS

FIG. 1 is a cross-sectional diagram of a common metal substrate heat dissipation structure;
FIG. 2 is a cross-sectional diagram of another common metal substrate heat dissipation structure;
FIG. 3 is a diagram of a cross-sectional structure of a metal substrate heat dissipation structure 100 according to an embodiment of this application;
FIG. 4 is a diagram of a cross-sectional structure of a metal substrate heat dissipation structure 200 according to an embodiment of this application;
FIG. 5(a) is a diagram of a cross-sectional structure of a first metal substrate heat dissipation structure according to an embodiment of this application;
FIG. 5(b) is a diagram of a cross-sectional structure of a second metal substrate heat dissipation structure according to an embodiment of this application;
FIG. 5(c) is a diagram of a cross-sectional structure of a third metal substrate heat dissipation structure according to an embodiment of this application;
FIG. 6 is a diagram of a cross-sectional structure of a metal substrate heat dissipation structure 300 according to an embodiment of this application;
FIG. 7 is a schematic top view of a metal substrate heat dissipation structure 300 according to an embodiment of this application;
FIG. 8(a) is a diagram of a cross-sectional structure of a fourth metal substrate heat dissipation structure according to an embodiment of this application;
FIG. 8(b) is a diagram of a cross-sectional structure of a fifth metal substrate heat dissipation structure according to an embodiment of this application; and
FIG. 8(c) is a diagram of a cross-sectional structure of a sixth metal substrate heat dissipation structure according to an embodiment of this application.

### DESCRIPTION OF EMBODIMENTS

A photovoltaic power optimizer can track a maximum power point of a single photovoltaic module in real time by using a unique software algorithm and circuit topology, to resolve a problem in which an electric energy yield of a photovoltaic system is reduced due to blocking and an orientation difference of the photovoltaic module, implement maximum power output of the single photovoltaic module, and improve power generation efficiency of the photovoltaic system.

With increasingly high requirements for low energy consumption, high efficiency, and high reliability of the photovoltaic power optimizer in the industry, heat dissipation of a power device inside the photovoltaic power optimizer is increasingly concerned. However, a heat dissipation structure in a conventional photovoltaic power optimizer is often formed by combining different discrete layers, and there are more bonding interfaces between layers. As a result, interface thermal resistance is large, heat dissipation efficiency is low, a quantity of used MOSes is large, and costs are increased.

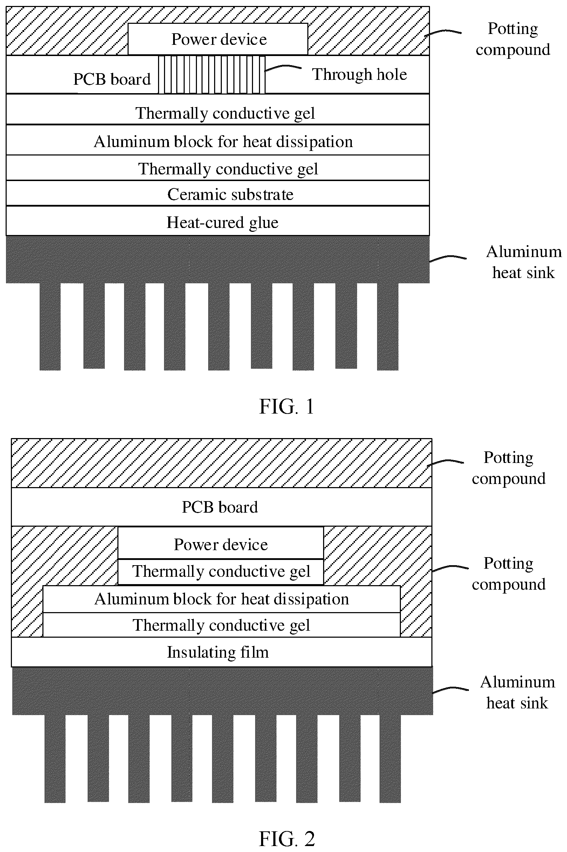

FIG. 1 is a cross-sectional diagram of a common metal substrate heat dissipation structure. A power device (for example, a MOS transistor or a diode) is disposed on a PCB, and implements unidirectional heat dissipation downward through high-density vias on the PCB. An aluminum substrate for heat dissipation and a ceramic substrate are sequentially disposed below the PCB, to implement enhanced heat dissipation effect and regulatory insulation effect respectively. Gaps between the PCB, the aluminum substrate for heat dissipation, and the ceramic substrate may be filled by using a thermally conductive medium (for example, thermally conductive silicone grease or gel), to reduce a hole between upper and lower layers, and therefore, better heat conduction effect is achieved. Besides, the ceramic substrate and an aluminum heat sink are connected and fastened through heat-cured glue. In addition, a grounded copper sheet or metal block may be further added between the MOS and a housing, to achieve shielding effect for noise feedback. This technology can achieve heat dissipation effect to some extent. However, because this solution relates to stacking of a plurality of discrete layers, there is thermal contact resistance between the layers. As a result, overall thermal resistance of the metal substrate heat dissipation structure is large, a quantity of required power devices is increased (to avoid excessively high temperature of the power device and improve working stability of the power device, more power devices need to be connected in parallel to reduce the temperature of the single power device), and costs are increased. In addition, in the discrete solution, baking needs to implement to achieve bonding and curing of a ceramic sheet that achieves insulation effect, and assembly and processing between layers are also troublesome.

FIG. 2 is a cross-sectional diagram of another common metal substrate heat dissipation structure. A power device is disposed below a PCB, and the power device includes two heat dissipation surfaces, which can implement bidirectional heat dissipation through upward and downward heat transfer paths respectively. On the downward heat transfer path of the power device, an aluminum block for heat dissipation and an insulating film are sequentially disposed on the structure, to implement an enhanced heat dissipation function and a regulatory insulation function respectively. Gaps between the layers, namely, the power device, the aluminum block for heat dissipation, and the insulating film, are also filled through a thermally conductive medium (for example, thermally conductive silicone grease or gel), to reduce interface thermal resistance and improve heat transfer efficiency. The thermal resistance of the structure is slightly smaller than that of the structure shown in FIG. 1. However, the power device, for example, a MOS transistor, in the structure is of a double-sided structure, and has a high technical requirement. In addition, the structure also relates to stacking of a plurality of discrete layers, making an installation structure complex. As a result, reliability of the structure may be reduced.

Based on the foregoing problems, embodiments of this application provide a metal substrate heat dissipation structure. The metal substrate heat dissipation structure is simpler, interface thermal resistance is greatly reduced, and heat dissipation efficiency is improved. In addition, the structure can also simplify a manufacturing process, improve reliability, and reduce material costs.

### Embodiment 1

Embodiment 1 of this application provides a metal substrate heat dissipation structure 100. The metal substrate heat dissipation structure 100 can simplify a manufacturing process, reduce material costs, and improve reliability while resolving a heat dissipation problem of a photovoltaic power optimizer.

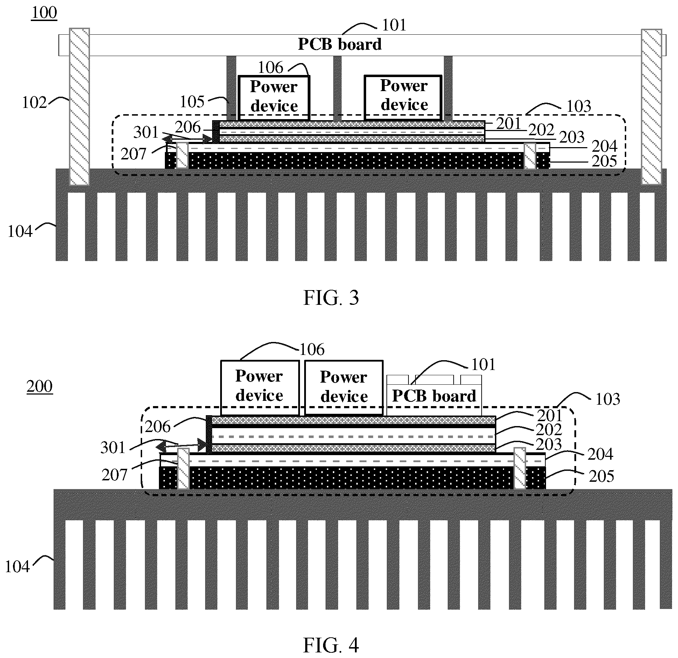

FIG. 3 is a cross-sectional diagram of a "castle-type" metal substrate heat dissipation structure 100 according to an embodiment of this application. As shown in FIG. 3, the metal substrate heat dissipation structure 100 includes a heat sink (metal housing) 104, a multi-layer metal plate 103 disposed above the heat sink 104, power devices 106 (devices that need heat dissipation such as a MOS transistor or a diode) disposed above the multi-layer metal plate 103, and a PCB 101 disposed above the multi-layer metal plate 103 through support of a metal conductor pillar 105, a metal frame, or the like or a connection or soldering (for example, reflow soldering or wave soldering) of a pin (Pin Header, pin header). The PCB 101 may be fastened to the heat sink 104 through a screw 102, clamping, or the like. The multi-layer metal plate 103 may be in direct contact or indirect contact with the heat sink 104 below the multi-layer metal plate 103. The direct contact is that the multi-layer metal plate 103 is fastened to the heat sink 104 through a screw 207, clamping, a pin, riveting, a spring clip, or the like, so that the multi-layer metal plate 103 is closely attached to the heat sink 104, to reduce a hole between the multi-layer metal plate 103 and the heat sink 104 and therefore improve heat dissipation efficiency. The indirect contact is that a thermally conductive material such as silicone grease or gel is applied between the multi-layer metal plate 103 and the heat sink 104, to reduce the hole between the multi-layer metal plate 103 and the heat sink 104 and therefore implement better heat conduction effect than that of air. A plurality of heat dissipation fins are provided on the heat sink 104, so that a heat exchange area can be increased and heat exchange efficiency can be improved. A material of the heat dissipation fin may be a metal or an alloy with high thermal conductivity, for example, copper or aluminum. It may be understood that a spatial location relationship among the heat sink 104, the multi-layer metal plate 103, and the PCB 101 makes the metal substrate heat dissipation structure 100 represent a "castle-type" structure. The multi-layer metal plate 103 can provide a first round of heat dissipation function, and the heat sink 104 can provide a second round of enhanced heat dissipation function.

Specifically, the multi-layer metal plate 103 is provided with a metal layer 201, an insulation layer 202, a metal layer 203, an insulation layer 204, and a metal substrate layer 205 sequentially from top to bottom along a height direction of the multi-layer metal plate 103, and the layers may be pressed and formed. The metal layer 201 and the metal layer 203 may be made of a material such as copper or aluminum. The metal substrate layer 205 may be made of a material with high heat conductivity, such as copper, aluminum, or an aluminum-copper alloy. The insulation layer 202 and the insulation layer 204 may be made of a PP material with high heat conductivity. Materials of the metal layers, the insulation layers, and the metal substrate layer 205 are not specifically limited herein.

The metal layer 201 is mainly configured to implement power interconnection between the power devices 106 and electrical interconnection between a control device on the PCB 101 and the plurality of power devices 106, and the metal layer 203 is mainly configured to implement an electromagnetic shielding function. Optionally, a thickness of the metal layer 201 is less than a thickness of the metal layer 203. In addition, to implement the electromagnetic shielding function of the metal layer 203, the metal layer 203 may be connected to a static point on the metal layer 201 through sidewall soldering/tin plating or a via 206. The static point is a point at which a potential in a circuit does not change abruptly. The metal layer 203 is connected to the static point, so that effect similar to that of grounding of a metal housing of the photovoltaic power optimizer can be implemented. Besides, the insulation layer 202 is disposed between the metal layer 201 and the metal layer 203, to implement functional insulation. A thickness of the insulation layer 204 disposed under the metal layer 203 may be more than 10 mil, to implement reinforced insulation. In addition, to better implement a regulatory function, projection areas of the metal layer 201, the insulation layer 202, and the metal layer 203 in a stacking direction of the multi-layer metal plate 103 are all less than projection areas of the metal layer 203 and the metal substrate layer 205 in the stacking direction of the multi-layer metal plate 103. That is, there is a specific regulatory distance 301 between edges of the metal layer 201, the insulation layer 202, and the metal layer 203 and edges of the insulation layer 204 and the metal substrate layer 205. The regulatory (regulatory) distance 301 is a shortest distance at which insulation can be implemented through air when electrical performance stability and safety of the multi-layer metal plate 103 are ensured. To shorten the regulatory distance 301 and improve heat dissipation efficiency of the metal substrate heat dissipation structure 100, a potting compound may also be further filled in a gap between the PCB 101 and the heat sink 104. Besides, the metal substrate layer 205 has high heat dissipation efficiency, and can enhance heat dissipation. In addition, the metal substrate layer 205 may further support the plurality of metal layers and the plurality of insulation layers in a vertical direction of the metal substrate layer 205.

In addition, due to material and structure limitations of the multi-layer metal plate 103, it is difficult to arrange and process complex traces on a surface and an inside of the multi-layer metal plate 103. In this case, in the metal substrate heat dissipation structure 100, the PCB 101 is mounted on the multi-layer metal plate 103 through disposition of a metal conductor pillar 105 or pin soldering (more economical), to dispose a complex control circuit and a corresponding control device on the PCB 101, so that the power device 106 is disposed on the multi-layer metal plate 103. This is convenient in processing and easy to implement. In addition to a support function, the disposition of the metal conductor pillar 105 or pin soldering can further implement electrical interconnection between the PCB 101 and the power device 106. In addition, it should be noted that the power device 106 has a higher temperature specification than the PCB 101. In other words, a temperature of the power device 106 during working is higher than that of the PCB 101. If the power device 106 is in direct contact with the PCB 101 for a long time, the power device 106 may bake the PCB 101. As a result, performance and reliability of the corresponding device on the PCB 101 deteriorate. Therefore, the metal substrate heat dissipation structure 100 can further alleviate the baking of the power device 106 to the PCB 101, and improve performance stability and reliability of the device.

It should be noted that the heat sink 104 and connecting pieces (for example, the screw 102 and the screw 207) between the heat sink 104 and both the PCB 101 and the multi-layer metal plate 103 are optional in the metal substrate heat dissipation structure 100. The heat sink 104 is disposed to continue to provide the second round of heat dissipation function after the multi-layer metal plate 103 provides the first round of heat dissipation function.

In conclusion, the "castle-type" metal substrate heat dissipation structure 100 fully utilizes advantages of flexible wiring of the PCB 101 and a strong heat dissipation capability of the metal substrate layer 205 of the multi-layer metal plate 103, has a simple structure, and is easy to process and mold. In addition, parts such as a ceramic piece and an aluminum block for heat dissipation in a common metal substrate heat dissipation structure are not needed in the multi-layer metal plate 103, so that the structure is simplified, and material costs are reduced. In addition, the simple structure of the multi-layer metal plate 103 also shortens a heat transfer path, so that total interface thermal resistance is reduced, heat dissipation efficiency is improved, and a quantity of used power devices can be reduced.

### Embodiment 2

Embodiment 2 of this application provides a metal substrate heat dissipation structure 200. The metal substrate heat dissipation structure 200 can simplify a manufacturing process, reduce material costs, and improve reliability while resolving a heat dissipation problem of a photovoltaic power optimizer.

FIG. 4 is a cross-sectional diagram of another metal substrate heat dissipation structure 200 according to Embodiment 2 of this application. A main difference between Embodiment 2 and Embodiment 1 lies in relative sizes of a PCB 101 and a multi-layer metal plate 103 and a location relationship between the PCB 101 and the multi-layer metal plate 103. As shown in FIG. 4, the metal substrate heat dissipation structure 200 includes a heat sink (a metal housing) 104, the multi-layer metal plate 103 disposed above the heat sink 104, power devices 106 (devices that need heat dissipation such as MOS transistors or diodes) disposed above the multi-layer metal plate 103, and the PCB 101 disposed above the multi-layer metal plate 103. The multi-layer metal plate 103 may be connected to the PCB 101 through pin connection, soldering, riveting, clamping, or the like. In Embodiment 2, when a volume or an area of the PCB 101 is small, the PCB 101 may be designed as a small board and directly disposed on a metal layer 201 of the multi-layer metal plate 103. Both the PCB 101 and the power devices 106 are directly disposed on the metal layer 201 of the multi-layer metal plate 103, so that a height of the metal substrate heat dissipation structure 200 can be reduced in a stacking direction, and therefore, a volume of the metal substrate heat dissipation structure 200 is reduced, a manufacturing process is simplified, and material costs are reduced. In addition, because an area of the multi-layer metal plate 103 is large, heat dissipation effect of the metal substrate heat dissipation structure 200 is also good. The multi-layer metal plate 103 may be in direct contact or indirect contact with the heat sink 104 below the multi-layer metal plate 103. The direct contact is that the multi-layer metal plate 103 is fastened to the heat sink 104 through a screw 207, clamping, a pin, riveting, a spring clip, or the like, so that the multi-layer metal plate 103 is closely attached to the heat sink 104, to reduce a hole between the multi-layer metal plate 103 and the heat sink 104 and therefore improve heat dissipation efficiency. The indirect contact is that a thermally conductive material such as silicone grease or gel is applied between the multi-layer metal plate 103 and the heat sink 104, to reduce the hole between the multi-layer metal plate 103 and the heat sink 104 and therefore implement better heat conduction effect than that of air. A plurality of heat dissipation fins are provided on the heat sink 104, so that a heat exchange area can be increased and heat exchange efficiency can be improved. A material of the heat dissipation fin may be a metal or an alloy with high thermal conductivity, for example, copper or aluminum.

Specifically, the multi-layer metal plate 103 is provided with the metal layer 201, an insulation layer 202, a metal layer 203, an insulation layer 204, and a metal substrate layer 205 sequentially from top to bottom along a height direction of the multi-layer metal plate 103, and the layers are pressed and formed. The metal layer 201 and the metal layer 203 may be made of a material such as copper or aluminum. The metal substrate layer 205 may be made of a material such as copper, aluminum, or an aluminum-copper alloy. The insulation layer 202 and the insulation layer 204 may be made of a PP material with high heat conductivity. Materials of the metal layers, the insulation layers, and the metal substrate layer 205 are not specifically limited herein.

The metal layer 201 is mainly configured to implement power interconnection between a plurality of power devices 106 and electrical interconnection between a control device on the PCB 101 and the plurality of power devices 106, and the metal layer 203 is mainly configured to implement an electromagnetic shielding function. In this case, a thickness of the metal layer 201 is less than a thickness of the metal layer 203. In addition, to implement the electromagnetic shielding function of the metal layer 203, the metal layer 203 is further connected to a static point on the metal layer 201 through sidewall soldering/tin plating or a via 206. Besides, the insulation layer 202 is disposed between the metal layer 201 and the metal layer 203, to implement a regulatory insulation function. A thickness of the insulation layer 204 disposed under the metal layer 203 may be more than 10 mil, to implement a reinforced insulation function. In addition, to better implement a regulatory function, projection areas of the metal layer 201, the insulation layer 202, and the metal layer 203 in the stacking direction of the multi-layer metal plate 103 are all less than projection areas of the metal layer 203 and the metal substrate layer 205 in the stacking direction of the multi-layer metal plate 103. That is, there is a specific regulatory distance 301 between edges of the metal layer 201, the insulation layer 202, and the metal layer 203 and edges of the insulation layer 204 and the metal substrate layer 205. The regulatory distance 301 is a shortest distance at which insulation can be implemented through air when electrical performance stability and safety of the multi-layer metal plate 103 are ensured. In addition, the metal substrate layer 205 may further support a top multi-layer structure.

Besides, due to material and structure limitations of the multi-layer metal plate 103, it is difficult to arrange and process complex traces on a surface and an inside of the multi-layer metal plate 103. In this case, the complex traces are disposed on the PCB 101 in Embodiment 2, and the power devices 106 are disposed on the multi-layer metal plate 103. Different from Embodiment 1, the PCB in Embodiment 2 is more integrated and has a smaller volume, and may be directly fastened to the multi-layer metal plate 103. Therefore, the metal conductor pillar 105 and the screw 102 in Embodiment 1 are not required, so that the process is simplified and material costs are reduced.

It should be noted that the heat sink 104 and a connecting piece (for example, the screw 207) between the heat sink 104 and the multi-layer metal plate 103 are optional in the metal substrate heat dissipation structure 200. The heat sink 104 is disposed to continue to provide a second round of heat dissipation function after the multi-layer metal plate 103 provides a first round of heat dissipation function.

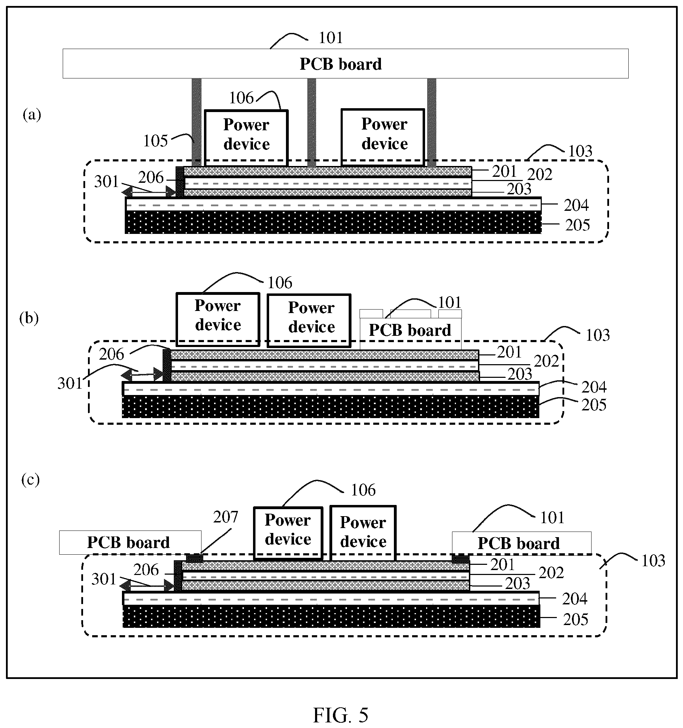

In addition, refer to FIG. 5. Location and size relationships between the PCB 101 and the multi-layer metal plate 103 in Embodiment 1 are shown in FIG. 5(a), and location and size relationships between the PCB 101 and the multi-layer metal plate 103 in Embodiment 2 are shown in FIG. 5(b). Besides, the location and size relationships between the PCB 101 and the multi-layer metal plate 103 may alternatively be shown in FIG. 5(c). An aperture is provided in the middle of the PCB 101 in the stacking direction, and an edge of the aperture of the PCB 101 is connected to a surface that is of the metal layer 201 and that is in a direction away from the insulation layer 202. The edge of the aperture of the holed PCB 101 may be connected to the metal layer 201 of the multi-layer metal plate 103 through soldering 207, riveting, clamping, or the like. The structure is simple and is easy to implement.

In conclusion, the metal substrate heat dissipation structure 200 in Embodiment 2 fully utilizes advantages of flexible wiring of the PCB 101 and a strong heat dissipation capability of the metal substrate layer 205 of the multi-layer metal plate 103, and a ceramic piece and an aluminum block for heat dissipation in a common metal substrate heat dissipation structure and the metal conductor pillar 105 in Embodiment 1 are not needed in the multi-layer metal plate 103, so that material costs are reduced. Besides, a simple structure of the multi-layer metal plate 103 also shortens a heat transfer path, so that total interface thermal resistance is reduced, and heat dissipation efficiency is improved.

### Embodiment 3

Embodiment 3 of this application provides another heat dissipation structure with a multi-layer metal plate 300. The metal substrate heat dissipation structure 300 can simplify a manufacturing process, reduce material costs, and improve reliability while resolving a heat dissipation problem of a photovoltaic power optimizer.

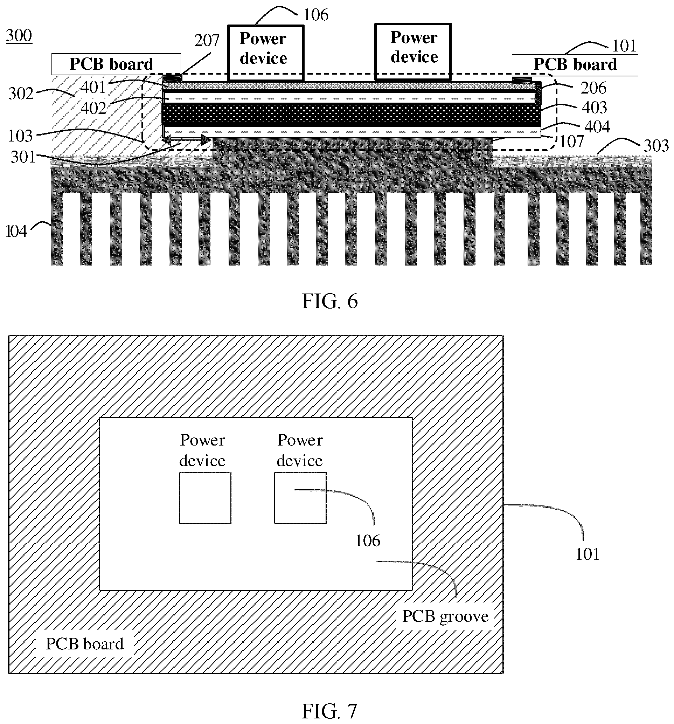

FIG. 6 is a cross-sectional diagram of another metal substrate heat dissipation structure 300 according to an embodiment of this application. A main difference between Embodiment 3 and both Embodiment 1 and Embodiment 2 lies in a structure and composition of a multi-layer metal plate 103 and a location relationship between a PCB 101 and the multi-layer metal plate 103. As shown in FIG. 6, the metal substrate heat dissipation structure 300 includes a heat sink 104, the multi-layer metal plate 103 disposed on the heat sink 104, power devices 106 disposed on a metal layer 401 of the multi-layer metal plate 103, and the holed PCB 101 disposed on the metal layer 401 of the multi-layer metal plate 103. The aperture is provided in the middle of the PCB 101 in a stacking direction, and an edge of the aperture of the PCB 101 is connected to a surface that is of the metal layer 401 and that is in a direction away from an insulation layer 402. The edge of the aperture of the PCB 101 may be connected to the metal layer 401 of the multi-layer metal plate 103 through soldering 207, riveting, clamping, or the like. The multi-layer metal plate 103 may be connected to the heat sink 104 through a thermally conductive material such as silicone grease, gel, or heat-cured glue, soldering, or the like, to reduce interface thermal resistance and improve heat transfer efficiency of the metal substrate heat dissipation structure 300.

Specifically, the multi-layer metal plate 103 is provided with the metal layer 401, the insulation layer 402, a metal substrate layer 403, and an insulation layer 404 sequentially from top to bottom along a height direction of the multi-layer metal plate 103, and the layers are pressed and formed. The metal layer 401 may be made of a material such as copper or aluminum. The metal substrate layer 403 may be made of a material with high heat conductivity, such as copper, aluminum, or an aluminum-copper alloy. The insulation layer 402 and the insulation layer 404 may be made of a PP material with high heat conductivity. Materials of the metal layer 401, the insulation layer 402, the metal substrate layer 403, and the insulation layer 404 are not specifically limited herein.

The metal layer 401 is mainly configured to implement power interconnection between a plurality of power devices 106 and electrical interconnection between a control device on the PCB 101 and the power device 106 on the multi-layer metal plate 103. Different from Embodiment 1 and Embodiment 2, the multi-layer metal plate 103 in Embodiment 3 may connect the metal substrate layer 403 to a static point on the metal layer 401 through sidewall soldering/tin plating, a via 206, or the like, to implement an electromagnetic shielding function. In addition to electromagnetic shielding effect, the metal substrate layer 403 may further enhance heat dissipation because the metal substrate layer 403 has a strong heat dissipation capability. The insulation layer 402 is disposed between the metal substrate layer 403 and the metal layer 401, to implement a functional insulation function. A thickness of the insulation layer 404 disposed under the metal substrate layer 403 may be more than 10 mil, to implement a reinforced insulation function. In addition, projection areas of the metal layer 401 and the insulation layer 402 in a stacking direction of the multi-layer metal plate 103 may be less than or equal to projection areas of the metal substrate layer 403 and the insulation layer 404 in the stacking direction of the multi-layer metal plate 103. That is, there may be a specific distance between edges of the metal layer 401 and the insulation layer 402 and edges of the metal substrate layer 403 and the insulation layer 404. The distance may facilitate sidewall soldering/tin plating or the via 206. In addition, there may be no specific distance between the edges of the metal layer 401 and the insulation layer 402 and the edges of the metal substrate layer 403 and the insulation layer 404. Electrical interconnection between the metal layer 401 and the metal substrate layer 403 is implemented directly through a through via. To ensure a sufficient regulatory distance 301, a protrusion structure 107 needs to exist on a side that is of the heat sink 104 and that is connected to the multi-layer metal plate 103, and the protrusion structure 107 needs to be connected to the multi-layer metal plate 103. The protrusion structure 107 and the heat sink 104 may be integrally formed, or may be fastened through soldering, riveting, clamping, or the like. An insulation layer 303 may be further disposed on two sides of the protrusion structure 107, to improve safety of the heat dissipation structure with the multi-layer metal plate 300. The insulation layer 303 may be fastened to the heat sink 104 through bonding, riveting, clamping, or the like. In addition, to shorten the regulatory distance 301, a potting compound 302 may be further filled between the PCB 101 and the insulation layer 303.

Besides, due to material and structure limitations of the multi-layer metal plate 103, it is difficult to arrange and process complex traces on a surface and an inside of the multi-layer metal plate 103. In this case, the complex traces are disposed on the PCB 101 in Embodiment 3, and the power devices 106 are disposed on the multi-layer metal plate 103. FIG. 7 is a schematic top view of the metal substrate heat dissipation structure 300 shown in FIG. 6. As shown in FIG. 7, an aperture is provided in the PCB 101, and a remaining PCB 101 is directly fastened to the multi-layer metal plate 103, so that the metal conductor pillar 105 in Embodiment 1 is not required to be disposed. Therefore, material costs are reduced, and the structure is simplified.

It should be noted that the heat sink 104 is optional in the metal substrate heat dissipation structure 300. The heat sink 104 is disposed to continue to provide a second round of heat dissipation function after the multi-layer metal plate 103 provides a first round of heat dissipation function.

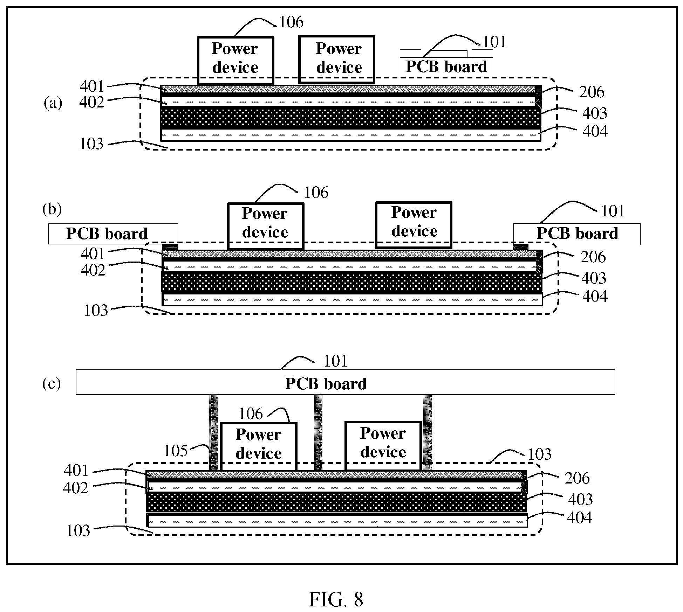

In addition, refer to FIG. 8. Location and size relationships between the PCB 101 and the multi-layer metal plate 103 in Embodiment 3 are shown in FIG. 8(b). Besides, the location and size relationships between the PCB 101 and the multi-layer metal plate 103 may alternatively be shown in FIG. 8(a) and FIG. 8(c). Specifically, in FIG. 8(a), a volume and an area of the PCB 101 are small. The PCB 101 may be fastened to the metal layer 401 of the multi-layer metal plate 103 through pin connection, soldering, riveting, clamping, or the like, so that a height of the metal substrate heat dissipation structure 300 in the stacking direction and a volume of the metal substrate heat dissipation structure 300 are reduced. In FIG. 8(c), the volume and the area of the PCB 101 are large. The PCB 101 may be mounted on the multi-layer metal plate 103 through the metal conductor pillar 105 or pin soldering, to relieve high-temperature baking of the power device 106 in a working state to the control device on the PCB 101.

In conclusion, the metal substrate heat dissipation structure 300 in Embodiment 3 fully utilizes advantages of flexible wiring of the PCB 101 and a strong heat dissipation capability of the multi-layer metal plate 103, has a simple structure, and is easy to process and mold. In addition, a ceramic piece and an aluminum block for heat dissipation in a common metal substrate heat dissipation structure, the metal conductor pillar 105 or the metal frame in Embodiment 1, and the metal layer 203 in Embodiment 1 or Embodiment 2 are not needed in the multi-layer metal plate 403, so that the structure is simplified, and material costs are reduced. Besides, the simple structure of the multi-layer metal plate 103 in Embodiment 3 also shortens a heat transfer path, so that total interface thermal resistance is reduced, and heat dissipation efficiency is improved.

### Embodiment 4

Embodiment 4 of this application provides a photovoltaic power optimizer. The photovoltaic power optimizer includes the metal substrate heat dissipation structure according to any one of Embodiment 1 to Embodiment 3 and a housing of the photovoltaic power optimizer. The metal substrate heat dissipation structure according to any one of Embodiment 1 to Embodiment 3 is placed in accommodation space enclosed by the housing of the photovoltaic power optimizer.

It is easily understood that, on the basis of the several embodiments provided in this application, a person skilled in the art can, for example, combine, split, or reorganize embodiments of this application to obtain other embodiments, and none of these embodiments go beyond the protection scope of this application.

In the foregoing specific implementations, the objectives, technical solutions, and technical effects of the present invention are described in detail. It should be understood that the foregoing descriptions are merely specific embodiments of the present invention, but are not intended to limit the protection scope of the present invention. Any modification, equivalent replacement, or improvement made based on the technical solutions of the present invention shall fall within the protection scope of the present invention.

## Claims

1. A metal substrate heat dissipation structure, wherein the metal substrate heat dissipation structure comprises:
a printed circuit board PCB, a multi-layer metal plate, and a power device, the multi-layer metal plate comprises a first metal layer, a first insulation layer, a second metal layer, and a second insulation layer that are sequentially stacked;
the first metal layer is electrically connected to the second metal layer, to implement electromagnetic shielding;
the power device is disposed on a surface that is of the first metal layer and that is in a direction away from the first insulation layer; and
the PCB is electrically connected to the first metal layer.

2. The metal substrate heat dissipation structure according to claim 1, wherein
the multi-layer metal plate further comprises a third metal layer, and the third metal layer is disposed under the second insulation layer.

3. The metal substrate heat dissipation structure according to claim 1, wherein
projection areas of the first metal layer and the first insulation layer in a stacking direction of the multi-layer metal plate are both less than or equal to projection areas of the second metal layer and the second insulation layer in the stacking direction of the multi-layer metal plate.

4. The metal substrate heat dissipation structure according to claim 2, wherein
projection areas of the first metal layer, the first insulation layer, and the second metal layer in a stacking direction of the multi-layer metal plate are all less than projection areas of the second insulation layer and the third metal layer in the stacking direction of the multi-layer metal plate.

5. The metal substrate heat dissipation structure according to any one of claims 1 to 4, wherein
a thickness of the second insulation layer is greater than a thickness of the first insulation layer.

6. The metal substrate heat dissipation structure according to any one of claims 1 to 5, wherein
the PCB is integrally disposed on the first metal layer of the multi-layer metal plate;
an aperture is provided in the middle of the PCB in the stacking direction, and an edge of the PCB aperture is connected to the surface that is of the first metal layer and that is in the direction away from the first insulation layer; or
the PCB is mounted above the multi-layer metal plate in the stacking direction and is located on the first metal layer.

7. The metal substrate heat dissipation structure according to any one of claims 1 to 6, wherein
the metal substrate heat dissipation structure further comprises a heat sink, and the heat sink is connected to the multi-layer metal plate.

8. The metal substrate heat dissipation structure according to claim 7, wherein
the metal substrate heat dissipation structure is fastened to the heat sink through a screw, silicone grease, gel, or heat-cured glue.

9. The metal substrate heat dissipation structure according to claim 8, wherein
a part that is of the heat sink and that is in contact with the multi-layer metal plate is of a protrusion structure, and the protrusion structure and the heat sink are of an integrated structure or a split structure.

10. The metal substrate heat dissipation structure according to claim 9, wherein
an insulation layer is disposed around the protrusion structure.

11. A photovoltaic power optimizer, wherein the photovoltaic power optimizer comprises the metal substrate heat dissipation structure according to any one of claims 1 to 10 and a housing of the photovoltaic power optimizer; and
the metal substrate heat dissipation structure is located in accommodation space enclosed by the housing of the photovoltaic power optimizer.

12. The photovoltaic power optimizer according to claim, wherein
a gap between the metal substrate heat dissipation structure and the housing of the photovoltaic power optimizer is filled with a potting compound.
